# EUROPEAN PATENT SPECIFICATION

(11) **EP 3 722 458 B1**
(45) Date of publication and mention of the grant of the patent: **19.01.2022**
(21) Application number: 19836781.5
(22) Date of filing: 28.02.2019
(51) Int. Cl.: C23C 16/455, B05B 13/00, H01L 31/18, C23C 16/448, C23C 16/458, C23C 16/54

(54) **FILM FORMING DEVICE**
FILMBILDENDE VORRICHTUNG
DISPOSITIF DE FORMATION DE FILM

(43) Date of publication of application: 14.10.2020
(73) Proprietor: TOSHIBA MITSUBISHI-ELECTRIC INDUSTRIAL SYSTEMS CORPORATION, Chuo-ku Tokyo 104-0031 (JP)
(72) Inventor: ORITA Hiroyuki, Tokyo 1040031 (JP); HIRAMATSU Takahiro, Tokyo 1040031 (JP); NAMITO Nobuyoshi, Tokyo 1040031 (JP); IWAO Yusuke, Tokyo 1040031 (JP)
(74) Representative: Winter, Brandl - Partnerschaft mbB
(86) International application number: PCT/JP2019/007750
(87) International publication number: WO 2020/174643

(56) References cited:
- WO-A1-2017/187500
- WO-A1-2017/187503
- CN-A- 102 615 010
- JP-A- S6 168 170
- JP-A- H07 259 828
- JP-A- 2001 508 356
- JP-A- 2010 077 508
- US-A1- 2013 084 391
- US-A1- 2016 153 085

## Description

### Technical Field

The present invention is used in manufacture of an electronic apparatus such as a solar battery, and relates to a film forming apparatus that forms a film on a substrate.

### Background Art

As a method of forming a film on a substrate, the chemical vapor deposition (CVD) method has been known. However, the chemical vapor deposition method often requires film formation in a vacuum, and thus a large vacuum chamber, as well as a vacuum pump etc., needs to be used. Further, in the chemical vapor deposition method, there has been a problem in that using a substrate having a large area as a substrate to be subjected to film formation is difficult from a point of view of costs or the like. In view of this, a misting method, which enables film forming treatment in atmospheric pressure, has been drawing attention.

As a conventional technology related to a film forming apparatus using such a misting method, for example, there is a technology according to WO 2017 / 068 625 A1.

In the technology according to WO 2017 / 068 625 A1, atomized source solution and reaction material are sprayed from a source solution ejection port and a reaction material ejection port that are provided on a bottom surface of a mist spray head unit including a mist spray nozzle etc. to a substrate disposed in an atmosphere. With such spraying, a film is formed on the substrate. Note that the reaction material refers to a material that contributes to a reaction with the source solution.

A conventional film forming apparatus typified in WO 2017 / 068 625 A1 forms a thin film on the substrate by simultaneously performing mist spraying treatment of a thin film forming nozzle and heating treatment of a heating mechanism.

Further, generally, a heating mechanism is provided inside a substrate placing stage that allows a substrate to be placed on its upper surface, and this substrate placing stage is used as a flat heating means.

CN 102 615 010 A discloses a vacuum spraying production line for helmets, which comprises a control system, a vacuum spraying system, a vacuum baking system and a conveying system.

### Summary

### Problem to be Solved by the Invention

As described above, generally, a conventional film forming apparatus has the following configuration. Specifically, a heating mechanism is provided inside a substrate placing stage that allows a substrate, which is a material as an object to be subjected to film formation, to be placed on its upper surface, and this substrate placing stage is used as a flat heating means.

When a flat heating means such as the substrate placing stage is used, heating treatment for a substrate is performed by bringing an upper surface of the substrate placing stage and a lower surface of a substrate to come in contact with each other and causing heat to transfer between the substrate placing stage and the substrate.

However, when a substrate has such a structure that a lower surface of the substrate is curved or a lower surface has a recessed portion and a projecting portion, instead of having a flat plate-like shape, the flat heating means allows an upper surface of the substrate placing stage and a back surface of the substrate to only locally come in contact with each other. Therefore, there have been problems in that heating of the substrate is uneven when heating treatment is performed by a heating mechanism, and a substrate is warped and deformed, for example.

The present invention has an object to solve the problems as described above, and provide a film forming apparatus that can form a thin film on a substrate and can enhance throughput of film forming treatment, without reducing film forming quality and a film forming rate.

### Means to Solve the Problem

A film forming apparatus according to the present invention includes a substrate conveying unit, a heating mechanism, and a mist spraying unit. The substrate conveying unit is configured to convey a substrate along a predetermined circle. The heating mechanism is provided in a heating chamber disposed along the predetermined circle. The heating mechanism is configured to perform heating treatment of heating the substrate without touching the substrate in the heating chamber. The mist spraying unit is provided in a film forming chamber disposed along the predetermined circle. The mist spraying unit is configured to perform mist spraying treatment of spraying source mist toward the substrate in the film forming chamber. The source mist is obtained by atomizing a source solution. The heating chamber and the film forming chamber are disposed separately from each other. Said substrate is conveyed along said predetermined circle by said substrate conveying unit to form a thin film on the substrate by performing the heating treatment of the heating mechanism in said heating chamber and then performing the mist spraying treatment of the mist spraying unit in said film forming chamber.

### Effects of the Invention

The film forming apparatus of an invention of the present application according to claim 1 includes the heating mechanism configured to perform heating treatment of heating a substrate without touching the substrate in the heating chamber. Therefore, through the heating treatment of the heating mechanism, a substrate can be uniformly heated, irrespective of the shape of a substrate.

Further, the heating mechanism and the mist spraying unit are disposed separately into the heating chamber and the film forming chamber, so that the heating treatment and the mist spraying treatment are not affected by each other. Therefore, the mist spraying treatment does not adversely affect the heating treatment.

As a result, the film forming apparatus of an invention of the present application according to claim 1 can form a thin film on a surface of the substrate without reducing film forming quality and a film forming rate, by performing the heating treatment of the heating mechanism and then performing the mist spraying treatment of the mist spraying unit.

Further, in the film forming apparatus of an invention of the present application according to claim 1, the heating chamber in which the heating mechanism is provided and the film forming chamber in which the mist spraying unit is provided are disposed on a predetermined circle, and a substrate is conveyed along the predetermined circle by the substrate conveying unit.

Therefore, when the film forming apparatus of an invention of the present application according to claim 1 uses the substrate conveying apparatus to convey the substrate so that the substrate is rotated a plurality of times on the predetermined circle, the number of heating mechanisms and mist spraying units can be minimized, and throughput of film forming treatment including the heating treatment and the mist spraying treatment can be enhanced.

These and other objects, features, aspects and advantages of the present invention will become more apparent from the following detailed description of the present invention when taken in conjunction with the accompanying drawings.

### Brief Description of Drawings

FIG. 1 is an explanatory diagram schematically illustrating a plan structure of a film forming apparatus being a first embodiment of the present invention.
FIG. 2 is a cross-sectional view illustrating a cross-sectional structure of the film forming apparatus of the first embodiment.
FIG. 3 is an explanatory diagram schematically illustrating a plan structure of a film forming apparatus being a second embodiment of the present invention.
FIG. 4 is an explanatory diagram schematically illustrating a plan structure of a film forming apparatus being a third embodiment of the present invention.
FIG. 5 is an explanatory diagram schematically illustrating a plan structure of a film forming apparatus being a fourth embodiment of the present invention.
FIG. 6 is a cross-sectional view illustrating a cross-sectional structure of the film forming apparatus of the fourth embodiment.
FIG. 7 is a (first) plan view illustrating a plan structure of a first aspect of a substrate holder of the fourth embodiment.
FIG. 8 is a (second) plan view illustrating a plan structure of the first aspect of the substrate holder of the fourth embodiment.
FIG. 9 is a cross-sectional view illustrating a cross-sectional structure taken along the line C-C of FIG. 8.
FIG. 10 is a (first) plan view illustrating a plan structure of a second aspect of the substrate holder of the fourth embodiment.
FIG. 11 is a (second) plan view illustrating a plan structure of the second aspect of the substrate holder of the fourth embodiment.
FIG. 12 is a cross-sectional view illustrating a cross-sectional structure taken along the line D-D of FIG. 11.
FIG. 13 is an explanatory diagram schematically illustrating a plan structure of a thin film forming nozzle in a film forming apparatus being a fifth embodiment of the present invention.
FIG. 14 is an explanatory diagram schematically illustrating a plan structure of a thin film forming nozzle being a first modification of the film forming apparatus of the fifth embodiment.
FIG. 15 is an explanatory diagram schematically illustrating a plan structure of a thin film forming nozzle being a second modification of the film forming apparatus of the fifth embodiment.
FIG. 16 is an explanatory diagram illustrating a schematic configuration of a film forming apparatus of basic art of the present invention.

### Description of Embodiments

### <Basic Art>

It is considered that, as a heating mechanism, an infrared radiation apparatus may be used instead of a conventional flat heating means. By using the infrared radiation apparatus, direct heating can be achieved with infrared light being electromagnetic waves, without touching a substrate. Therefore, uniform heating can be achieved, irrespective of the shape of a substrate.

However, there has been a problem. Specifically, source mist, which is obtained by atomizing a source solution, absorbs infrared light and the source mist is thereby heated and evaporated, causing reduction in film forming quality of a thin film formed on a substrate and a film forming rate in film forming treatment. Further, there has been another problem. Specifically, mist spraying treatment itself of spraying source mist hinders heating of a substrate.

To solve these problems, an improved manufacturing method is conceived. In the improved manufacturing method, a heating process and a film forming process (mist spraying process) are separated from each other, and are performed in different spaces. By using this improved manufacturing method, irrespective of the shape of a substrate, film formation is enabled without reducing film forming quality of a thin film and a film forming rate in film forming treatment.

However, a temperature of a substrate sharply drops immediately after the substrate goes through a heating process, and thus the heating process and the film forming process need to be repeated. Therefore, a first method is conceived. In the first method, a plurality of heating mechanisms that perform heating treatment and a plurality of mist spraying units that perform mist spraying treatment are prepared, and the plurality of (a large number of) heating mechanisms and the plurality of (a large number of) mist spraying units are alternately arrayed. Further, a second method is conceived. In the second method, a substrate between a single heating mechanism and a single mist spraying unit is caused to move backward and forward a plurality of times.

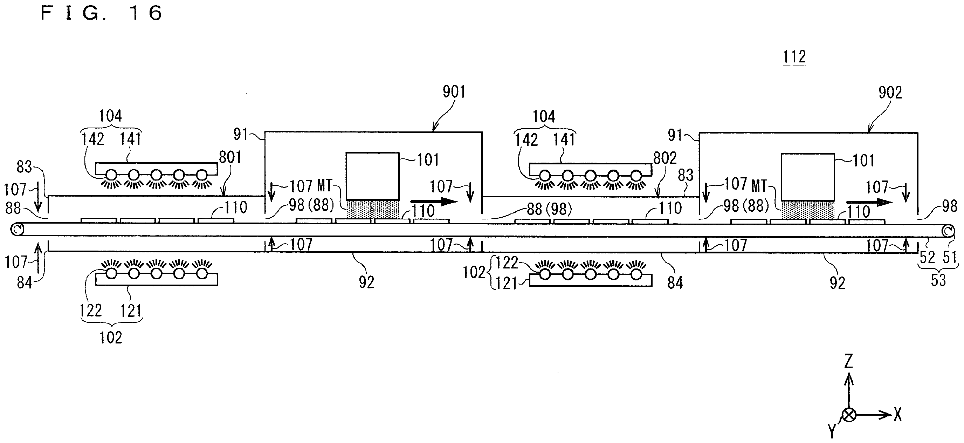

FIG. 16 is an explanatory diagram illustrating a schematic configuration of a film forming apparatus that embodies the first method of the basic art of the present invention. An XYZ orthogonal coordinate system is illustrated in FIG. 16.

As illustrated in FIG. 16, a thin film manufacturing apparatus 112 of the basic art includes, as its main components, heating chambers 801 and 802, film forming chambers 901 and 902, two thin film forming nozzles 101, combinations of two pairs of infrared radiation apparatuses 102 and 104, and a conveyor 53.

The infrared radiation apparatus 102 consists of a lamp placing table 121 and a plurality of infrared lamps 122. The plurality of infrared lamps 122 are attached to an upper portion of the lamp placing table 121. Therefore, the infrared radiation apparatus 102 can radiate infrared light upward (+Z direction) from the plurality of infrared lamps 122. With the above-mentioned infrared radiation of the infrared radiation apparatus 102, heating treatment (first direction heating treatment) for a back surface of a plurality of substrates 110 placed on an upper surface of a belt 52 can be performed.

The infrared radiation apparatus 104 consists of a lamp placing table 141 and a plurality of infrared lamps 142. The plurality of infrared lamps 142 are attached to a lower portion of the lamp placing table 141. Therefore, the infrared radiation apparatus 104 can radiate infrared light downward (-Z direction) from the plurality of infrared lamps 142. With the above-mentioned infrared radiation of the infrared radiation apparatus 104, heating treatment (second direction heating treatment) for a front surface of a plurality of substrates 110 placed on an upper surface of the belt 52 can be performed.

The conveyor 53 being a substrate conveying unit allows a plurality of substrates 110 to be placed on an upper surface of the belt 52, and conveys the plurality of substrates 110 in a conveying direction (X direction). The conveyor 53 includes a pair of rollers 51 for conveyance provided at both right and left ends, and an endless belt 52 for conveyance that is stretched across the pair of rollers 51.

With rotational drive of the pair of rollers 51, the conveyor 53 can move the belt 52 on an upper side (+Z direction side) along the conveying direction (X direction).

Of the pair of rollers 51 of the conveyor 53, one roller is provided on the left side (-X direction) out of the heating chamber 801, and the other roller is provided on the right side (+X direction) of the film forming chamber 902. Further, a center portion of the belt 52 is provided inside any of the heating chamber 801, the heating chamber 802, the film forming chamber 901, and the film forming chamber 902.

Therefore, with rotational drive of the pair of rollers 51, the belt 52 can be moved between the inside of the heating chambers 801 and 802, the inside of the film forming chambers 901 and 902, and the outside, through a pair of opening portions 88 provided at a portion of respective side surfaces on the right and left (-X direction,+ X direction) of the heating chambers 801 and 802 and a pair of opening portions 98 provided at a portion of respective side surfaces on the right and left of the film forming chambers 901 and 902.

The heating chambers 801 and 802 and the film forming chambers 901 and 902 are adjacently provided from the left side to the right side in the order of the heating chamber 801, the film forming chamber 901, the heating chamber 802, and the film forming chamber 902. Further, the right opening portion 88 of the heating chamber 801 and the left opening portion 98 of the film forming chamber 901 are shared. The right opening portion 98 of the film forming chamber 901 and the left opening portion 88 of the heating chamber 802 are shared. The right opening portion 88 of the heating chamber 802 and the opening portion 98 of the film forming chamber 902 are shared.

A part of the conveyor 53 is accommodated in the heating chambers 801 and 802. The configuration inside and around the heating chambers 801 and 802 are the same, and thus the heating chamber 801 will be mainly described below.

The heating chamber 801 consists of an upper chamber 83, a lower chamber 84, and a pair of opening portions 88. The pair of opening portions 88 is located between the upper chamber 83 and the lower chamber 84 in a height direction being the Z direction. Therefore, the conveyor 53 provided between the opening portions 88 and 88 in the heating chamber 201 is disposed at a position higher than the lower chamber 84, and at a position lower than the upper chamber 83.

In an area around the heating chamber 801, the infrared radiation apparatus 102 being a first direction heating unit is fixed at a position apart from the conveyor 53 on a lower side (-Z direction) side out of the lower chamber 84 by a fixing means (not shown).

In an area around the heating chamber 801, the infrared radiation apparatus 104 being a second direction heating unit is fixed at a position apart from the conveyor 53 on an upper side (+Z direction) side out of the upper chamber 83 by a fixing means (not shown). The infrared radiation apparatus 102 and the infrared radiation apparatus 104 constitute a heating mechanism.

Note that both of the infrared radiation apparatuses 102 and 104 are disposed at positions overlapping an upper surface area (area interposed between a pair of linear conveyor chains) of the belt 52 in the heating chamber 801 in plan view.

As a material, each of the heating chambers 801 and 802 uses an infrared light transmitting material that has an excellent transmitting property and that does not absorb infrared light radiated from the infrared radiation apparatuses 102 and 104. Specifically, as a material, each of the heating chambers 801 and 802 uses quartz glass.

The infrared radiation apparatus 102 being a first direction heating unit performs first direction heating treatment of heating the substrate 110 from a back surface side, by radiating infrared light from a back surface side (another main surface side) of the substrate 110 toward the +Z direction (first direction).

The infrared radiation apparatus 104 being a second direction heating unit performs second direction heating treatment of heating the substrate 110 from a front surface side, by radiating infrared light from a front surface side (one main surface side) of the substrate 110 toward the -Z direction (second direction) being a direction opposite to the +Z direction.

Further, the heating chamber 801 accommodates the substrate 110 in its inside, when the heating treatment (first direction heating treatment and second direction heating treatment) of the infrared radiation apparatuses 102 and 104 is performed.

The heating chamber 801 closes the opening portions 88 between the upper chamber 83 and the lower chamber 84 with an air curtain 107 when heating treatment is performed. In this manner, a plurality of substrates 110 placed on the belt 52 can be insulated from the outside.

As described above, the thin film manufacturing apparatus 112 of the basic art includes the infrared radiation apparatuses 102 and 104 provided around the outside of the heating chamber 801 as a first heating mechanism, and the infrared radiation apparatuses 102 and 104 provided around the outside of the heating apparatus 802 as a second heating mechanism.

Further, first heating treatment is performed by the infrared radiation apparatuses 102 and 104 for a plurality of substrates 110 in the heating chamber 801, and second heating treatment is performed by the infrared radiation apparatuses 102 and 104 for a plurality of substrates 110 in the heating chamber 802. These first and second heating treatments include the first direction heating treatment and the second direction heating treatment, respectively.

Each of the film forming chambers 901 and 902 accommodates the thin film forming nozzle 101 and a part of the conveyor 53. The internal configurations of the film forming chambers 901 and 902 are the same, and thus the film forming chamber 901 will be mainly described below.

The heating chamber 901 consists of an upper chamber 91, a lower chamber 92, and a pair of opening portions 98. The pair of opening portions 98 is located between the upper chamber 91 and the lower chamber 92 in the height direction being the Z direction. Therefore, the conveyor 53 provided between the opening portions 98 and 98 in the film forming chamber 901 is disposed at a position higher than the lower chamber 92, and at a position lower than the upper chamber 91.

In the film forming chamber 901, the thin film forming nozzle 101 being a mist spraying unit is fixedly disposed in the upper chamber 91 by a fixing means (not shown). In this case, the thin film forming nozzle 101 is disposed to have such a positional relationship that a spray surface and an upper surface of the belt 52 face each other.

In the film forming chamber 901, the thin film forming nozzle 101 performs mist spraying treatment of spraying source mist MT downward (-Z direction) from a spray port provided on a spray surface.

As described above, the thin film manufacturing apparatus 112 of the basic art includes the thin film forming nozzle 101 provided in the film forming chamber 901 as a first mist spraying unit, and the thin film forming nozzle 101 provided in the film forming chamber 902 as a second mist spraying unit.

Further, first mist spraying treatment is performed by the thin film forming nozzle 101 provided in the film forming chamber 901, and second mist spraying treatment is performed by the thin film forming nozzle 101 provided in the film forming chamber 902.

Each of the film forming chambers 901 and 902 closes the opening portions 98 between the upper chamber 91 and the lower chamber 92 with an air curtain 107 when mist spraying treatment is performed. In this manner, the thin film forming nozzle 101 and a plurality of substrates 110 placed on the belt 52 can be insulated from the outside.

Therefore, when the thin film manufacturing apparatus 112 of the basic art uses the air curtain 107 to close all of the pair of opening portions 88 of respective heating chambers 801 and 802 and the pair of opening portions 98 of respective film forming chambers 901 and 902, and moves the belt 52 of the conveyor 53 along the conveying direction (X direction), the thin film manufacturing apparatus 112 of the basic art can set a film forming environment.

In the thin film manufacturing apparatus 112 of the basic art, combinations of the two pairs of infrared radiation apparatuses 102 and 104 and the two thin film forming nozzles 101 are disposed separately from each other, so that heating treatment performed for the substrate 110 in the heating chambers 801 and 802 and mist spraying treatment performed for the substrate 110 in the film forming chambers 901 and 902 are not affected by each other in the film forming environment.

Then, in the thin film manufacturing apparatus 112 of the basic art, in the film forming environment, the first heating treatment of infrared radiation of the infrared radiation apparatuses 102 and 104 is performed for a plurality of substrates 110 in the heating chamber 801. Subsequently, the first mist spraying treatment of the thin film forming nozzle 101 is performed in the film forming chamber 901.

After that, in the thin film manufacturing apparatus 112, in the film forming environment, the second heating treatment of infrared radiation of the infrared radiation apparatuses 102 and 104 is performed for a plurality of substrates 110 in the heating chamber 802. Subsequently, the second mist spraying treatment of the thin film forming nozzle 101 is performed in the film forming chamber 902.

As a result, the thin film manufacturing apparatus 112 of the basic art can finally form a thin film on a surface of the substrate 110 placed on an upper surface of the belt 52 in the film forming chamber 902.

As described above, the thin film manufacturing apparatus 112 of the basic art can heat the substrate 110 with combinations of the two pairs of infrared radiation apparatuses 102 and 104, without touching the substrate 110. Therefore, the thin film manufacturing apparatus 112 of the basic art can perform uniform heating, irrespective of the shape of the substrate 110, without deforming the substrate 110.

Further, in the thin film manufacturing apparatus 112 of the basic art, the two pairs of infrared radiation apparatuses 102 and 104 and the two thin film forming nozzles 101 are disposed separately from each other, so that the heating treatment and the mist spraying treatment are not affected by each other. Therefore, the thin film manufacturing apparatus 112 can securely avoid occurrence of the source mist evaporation phenomenon, when each of the first and second heating treatments and the first and second mist spraying treatments is performed.

As a result, the thin film manufacturing apparatus 112 of the basic art can form a thin film on a surface of the substrate 110, without reducing film forming quality and a film forming rate.

As described above, in the thin film manufacturing apparatus 112 of the basic art, the first and second heating mechanisms and the first and second mist spraying units are alternately disposed in the order of first and second, so that the first and second heating treatments and the first and second mist spraying treatments are not affected by each other.

Further, the thin film manufacturing apparatus 112 of the basic art has a feature in that the first and second heating treatments and the first and second mist spraying treatments are alternately performed in the order of first and second.

Therefore, the thin film manufacturing apparatus 112 of the basic art can increase the thickness of a formed thin film, and can form a thin film with a stacking structure consisting of two films having different film qualities, by performing the heating treatment and the mist spraying treatment alternately repeated twice.

Note that, in the thin film manufacturing apparatus 112 described above, a combination of two heating mechanisms and two mist spraying units is illustrated. However, an extended modification, which is achieved by a combination of n (n ≥ 2) heating mechanisms and n mist spraying units, can be implemented.

The extended modification includes first to n-th heating mechanisms that perform first to n-th heating treatments, and first to n-th mist spraying units that perform first to n-th mist spraying treatments.

In the extended modification, the first to n-th heating mechanisms and the first to n-th mist spraying units are alternately disposed separately from each other in the order of first to n-th, so that the first to n-th heating treatments and the first to n-th mist spraying treatments are not affected by each other.

Further, the extended modification has a feature in that the first to n-th heating treatments and the first to n-th mist spraying treatments are alternately performed in the order of first, second, ..., n-th.

Therefore, the extended modification can increase the thickness of a formed thin film, and can form a thin film with a stacking structure consisting of films of n layers having different film qualities, by performing the heating treatment and the mist spraying treatment alternately repeated n (≥ 2) times.

In addition, the thin film manufacturing apparatus 112 of the basic art simultaneously perform the first direction heating treatment of the infrared radiation apparatus 102 and the second direction heating treatment of the infrared radiation apparatus 104, as the first and second heating treatments performed for the substrate 110 in the heating chambers 801 and 802.

As a result, the thin film manufacturing apparatus 112 of the basic art can more uniformly heat the substrate 110 in each of the heating chambers 801 and 802.

However, in the first method typified by the basic art as illustrated in FIG. 16, there has been a problem. Specifically, a plurality of infrared radiation apparatuses 102 and 104 being heating mechanisms and a plurality of thin film forming nozzles 101 being mist spraying units need to be provided, which increases costs.

In contrast, the second method has the following problem. Specifically, when movement is caused between a single heating mechanism and a single mist spraying unit, wasteful time in which neither the heating treatment nor the mist spraying treatment is performed is invariably generated, which reduces throughput of film forming treatment.

Embodiments to be described below have an object to solve the problems of the first and second methods, minimize the number of heating mechanisms and mist spraying units, and enhance throughput of film forming treatment.

### <First Embodiment>

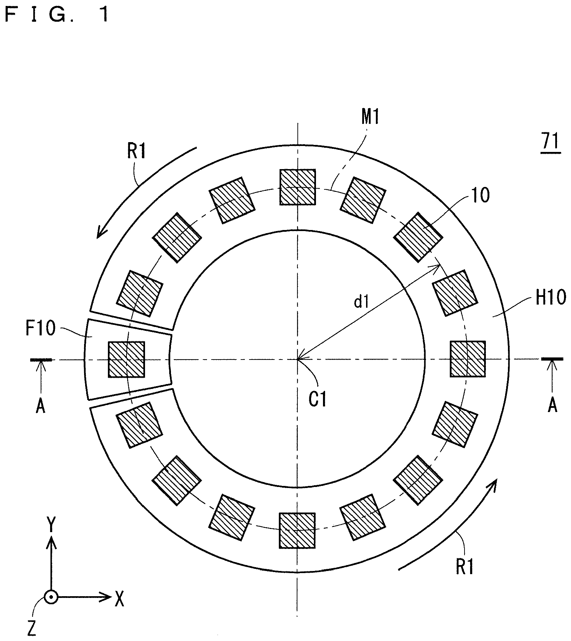

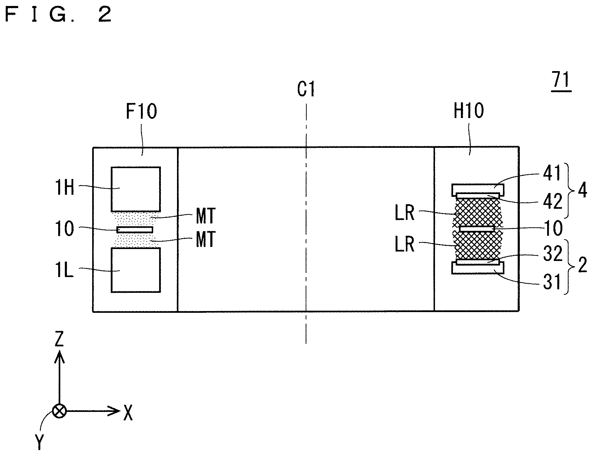

FIG. 1 is an explanatory diagram schematically illustrating a plan structure of a film forming apparatus 71 being a first embodiment of the present invention. FIG. 2 is a cross-sectional view illustrating a cross-sectional structure of the film forming apparatus 71 of the first embodiment. FIG. 2 illustrates a cross-section taken along the line A-A of FIG. 1. An XYZ orthogonal coordinate system is illustrated in each of FIG. 1 and FIG. 2.

As illustrated in FIG. 1, a substrate conveyance path circle M1 (predetermined circle) being a circle having a radius d1 and a center point C1 as its center is set.

Each of a heating chamber H10 and a film forming chamber F10 is disposed separately from each other along the substrate conveyance path circle M1 in an arc shape. The heating chamber H10 and the film forming chamber F10 are disposed adjacently to each other, and are provided not to have a substantial empty space on the substrate conveyance path circle M1.

With a substrate conveying apparatus 8 to be described later in detail, a plurality of substrates 10 are simultaneously conveyed along the substrate conveyance path circle M1, with a substrate rotation direction R1 being a moving direction. Each of the plurality of substrates 10 has a rectangular shape in plan view. The plurality of substrates 10 are conveyed such that the center of each of the plurality of substrates 10 is always located on the substrate conveyance path circle M1.

As illustrated in FIG. 2, an infrared radiation apparatus 2 being a first direction heating unit is fixed by a fixing means (not shown) at a position apart from the substrate 10 in the heating chamber H10. An infrared radiation apparatus 4 being a second direction heating unit is fixed by a fixing means (not shown) at a position apart from the substrate 10 in the heating chamber H10. A combination of the infrared radiation apparatus 2 and the infrared radiation apparatus 4 constitute a heating mechanism. The heating chamber H10 does not have an opening area that connects to the outside, except a rotation side surface opening area to be described later.

Note that a plurality of infrared radiation apparatuses 2 and 4 are disposed in a distributed manner in a rectangular shape in plan view in the heating chamber H10. For example, a plurality of infrared radiation apparatuses 2 and 4 are disposed in a distributed manner at positions corresponding to a plurality of substrates 10 (fifteen substrates 10) illustrated in FIG. 1. Further, the infrared radiation apparatuses 2 and 4 are provided to have a shape slightly larger than the substrate 10, so that the infrared radiation apparatuses 2 and 4 include the entire substrate 10 in plan view when the substrate 10 is conveyed along the substrate conveyance path circle M1.

As described above, although a plurality of infrared radiation apparatuses 2 and 4 are provided in a distributed manner in the heating chamber H10, only a pair of infrared radiation apparatuses 2 and 4 will be described below for the sake of convenience in description.

The infrared radiation apparatus 2 consists of a lamp placing table 31 and an infrared lamp 32. The infrared lamp 32 is attached to an upper portion of the lamp placing table 31. Therefore, the infrared radiation apparatus 2 can radiate infrared light LR upward (+Z direction (first direction)) from the infrared lamp 32. With the above-mentioned infrared radiation of the infrared radiation apparatus 2, heating treatment (first direction heating treatment) for the substrate 10 can be performed.

The infrared radiation apparatus 4 consists of a lamp placing table 41 and an infrared lamp 42. The infrared lamp 42 is attached to a lower portion of the lamp placing table 41. Therefore, the infrared radiation apparatus 4 can radiate infrared light LR downward (-Z direction) from the infrared lamp 42. With the above-mentioned infrared radiation of the infrared radiation apparatus 4, heating treatment (second direction heating treatment) for the substrate 10 can be performed.

As described above, the infrared radiation apparatus 2 being a first direction heating unit performs first direction heating treatment of heating the substrate 10 without touching the substrate 10, by radiating the infrared light LR toward the +Z direction (first direction). The +Z direction corresponds to a direction from a back surface to a front surface of the substrate 10.

In contrast, the infrared radiation apparatus 4 being a second direction heating unit performs second direction heating treatment of heating the substrate 10 without touching the substrate 10, by radiating the infrared light LR toward the -Z direction (second direction) being a direction opposite to the +Z direction. The -Z direction corresponds to a direction from a front surface to a back surface of the substrate 10.

As described above, the infrared radiation apparatuses 2 and 4 are provided in the heating chamber H10, and serve as a heating mechanism that performs heating treatment (first direction heating treatment + second direction heating treatment) of heating the substrate 10 in the heating chamber H10.

A thin film forming nozzle 1L being a first direction mist spraying unit is fixedly disposed in the film forming chamber F10 so as to be located on a lower side of the substrate 10 by a fixing means (not shown). In this case, the thin film forming nozzle 1L is disposed to have such a positional relationship that a mist spray port and a back surface of the substrate 10 face each other.

A thin film forming nozzle 1H being a second direction mist spraying unit is fixedly disposed in the film forming chamber F10 by a fixing means (not shown). In this case, the thin film forming nozzle 1H is disposed to have such a positional relationship that a mist spray port and a front surface of the substrate 10 face each other. Note that the film forming chamber F10 does not have an opening area that connects to the outside, except a rotation side surface opening area to be described later.

In the film forming chamber F10, the thin film forming nozzle 1L performs first direction mist spraying treatment of spraying source mist MT upward (+Z direction; first direction) from the mist spray port.

In the film forming chamber F10, the thin film forming nozzle 1H performs second direction mist spraying treatment of spraying source mist MT downward (-Z direction; second direction) from the mist spray port.

As described above, the film forming apparatus 71 of the first embodiment includes the thin film forming nozzle 1L as the first direction mist spraying unit, and the thin film forming nozzle 1H as the second direction mist spraying unit. Therefore, a combination of the thin film forming nozzles 1L and 1H of the film forming apparatus 71 of the first embodiment constitute a mist spraying unit. The mist spraying unit performs mist spraying treatment consisting of the combination of the first direction mist spraying treatment and the second direction mist spraying treatment.

As described above, the thin film forming nozzles 1L and 1H are provided in the film forming chamber F10 disposed along the substrate conveyance path circle M1, and serve as a mist spraying unit that performs mist spraying treatment of spraying the source mist MT, which is obtained by atomizing a source solution, toward the substrate 10 in the film forming chamber F10.

In the film forming apparatus 71 of the first embodiment having such a configuration, a plurality of substrates 10 (sixteen substrates 10 in FIG. 1) are conveyed along the substrate conveyance path circle M1 in the substrate rotation direction R1 by the substrate conveying apparatus 8 (not shown). Then, after the heating treatment of the infrared radiation apparatuses 2 and 4 (heating mechanism) in the heating chamber H10 is performed, the mist spraying treatment of the thin film forming nozzles 1L and 1H (mist spraying unit) in the film forming chamber F10 is performed. In this manner, a thin film is formed on each of a front surface and a back surface of the plurality of substrates 10.

The film forming apparatus 71 of the first embodiment includes the heating mechanism (infrared radiation apparatuses 2 and 4) that performs the heating treatment of heating the substrate 10 without touching the substrate 10 in the heating chamber H10. Therefore, through the heating treatment of the heating mechanism, the film forming apparatus 71 of the first embodiment can uniformly heat the substrate, irrespective of the shape of the substrate 10.

Further, the heating mechanism and the mist spraying unit are disposed separately into the heating chamber H10 and the film forming chamber F10, so that the heating treatment and the mist spraying treatment are not affected by each other. Therefore, the mist spraying treatment does not adversely affect the heating treatment.

As a result, the film forming apparatus 71 of the first embodiment can form a thin film on the substrate 10 without reducing film forming quality and a film forming rate, by performing the heating treatment of the heating mechanism and then performing the mist spraying treatment of the mist spraying unit.

In the film forming apparatus 71 of the first embodiment, the heating chamber H10, in which the infrared radiation apparatuses 2 and 4 (heating mechanism) are provided, and the film forming chamber F10, in which the thin film forming nozzles 1L and 1H (mist spraying unit) are provided, are disposed on the substrate conveyance path circle M1 (predetermined circle). A plurality of substrates 10 are simultaneously conveyed along the substrate conveyance path circle M1 by the substrate conveying apparatus 8 (substrate conveying unit).

Therefore, when the film forming apparatus 71 of the first embodiment uses the substrate conveying apparatus 8 to convey a plurality of substrates 10 so that the plurality of substrates 10 are rotated a plurality of times on the substrate conveyance path circle M1, the number of infrared radiation apparatuses 2 and 4 and thin film forming nozzles 1L and 1H can be minimized, and throughput of film forming treatment including the heating treatment and the mist spraying treatment can be enhanced.

This is because of the following reason. Specifically, since both of the heating chamber H10 and the film forming chamber F10 are disposed along the substrate conveyance path circle M1, when each of a plurality of substrates 10 is repeatedly rotated along the substrate conveyance path circle M1, the infrared radiation apparatuses 2 and 4 provided in the heating chamber H10 and the thin film forming nozzles 1L and 1H provided in the film forming chamber F10 can be used for the heating treatment and the mist spraying treatment a plurality of times.

Note that the above effects can be produced also when the number of substrates to be conveyed is one. Further, when the film forming chamber F10 and the heating chamber H10 are adjacently disposed without providing a gap on the substrate conveyance path circle M1, a transition time period from the heating treatment to the mist spraying treatment, and from the mist spraying treatment to the heating treatment, can be substantially brought close to "0." Therefore, the film forming apparatus 71 of the first embodiment can further enhance throughput of film forming treatment for a thin film.

Further, the film forming apparatus 71 of the first embodiment can even further enhance throughput of film forming treatment, since a plurality of substrates are simultaneously conveyed to be rotated along the substrate conveyance path circle M1.

In addition, the film forming apparatus 71 of the first embodiment simultaneously performs the first direction heating treatment of the infrared radiation apparatus 2 and the second direction heating treatment of the infrared radiation apparatus 4, as the heating treatment performed in the heating chamber H10. Therefore, a back surface of the substrate 10 can be heated through the first direction heating treatment, and a front surface of the substrate 10 can be heated through the second direction heating treatment.

As a result, the film forming apparatus 71 of the first embodiment can more uniformly heat the substrate 10 in the heating chamber H10.

Further, the film forming apparatus 71 of the first embodiment can form a thin film on each of a back surface and a front surface of a substrate, by simultaneously performing the first direction mist spraying treatment of the thin film forming nozzle 1L and the second direction mist spraying treatment of the thin film forming nozzle 1H.

### <Second Embodiment>

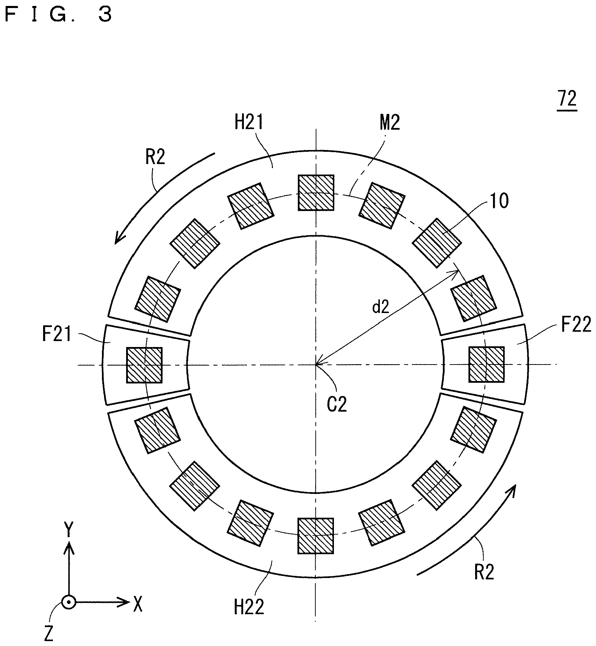

FIG. 3 is an explanatory diagram schematically illustrating a plan structure of a film forming apparatus 72 being a second embodiment of the present invention. An XYZ orthogonal coordinate system is illustrated in FIG. 3. In the following, features specific to the film forming apparatus 72 of the second embodiment will be mainly described, and description of features similar to those of the film forming apparatus 71 of the first embodiment will be omitted as appropriate.

As illustrated in FIG. 3, a substrate conveyance path circle M2 (predetermined circle) being a circle having a radius d2 and a center point C2 as its center is set.

Each of heating chambers H21 and H22 and film forming chambers F21 and F22 is disposed separately from each other along the substrate conveyance path circle M2 in an arc shape. The heating chambers H21 and H22 and the film forming chambers F21 and F22 are disposed adjacently to each other along a substrate rotation direction R2 in the order of the heating chamber H21, the film forming chambers F21, the heating chamber H22, and the film forming chamber F22, and are provided not to have a substantial empty space on the substrate conveyance path circle M2.

With a substrate conveying apparatus 8 to be described later in detail, a plurality of substrates 10 are simultaneously conveyed along the substrate conveyance path circle M2, with the substrate rotation direction R2 being a moving direction.

The infrared radiation apparatuses 2 and 4 being first and second direction heating units are attached inside each of the heating chambers H21 and H22, in a similar manner to the infrared radiation apparatuses 2 and 4 of the first embodiment attached inside the heating chamber H10. Each of the heating chambers H21 and H22 is provided without an opening area that connects to the outside, except a rotation side surface opening area to be described later.

Note that a plurality of infrared radiation apparatuses 2 and 4 are disposed in a distributed manner in a rectangular shape in plan view in each of the heating chambers H21 and H22. For example, a plurality of infrared radiation apparatuses 2 and 4 (seven pairs of infrared radiation apparatuses 2 and 4) are disposed in a distributed manner at positions corresponding to a plurality of substrates 10 (seven substrates 10) illustrated in FIG. 3, in each of the heating chambers H21 and H22. Further, the infrared radiation apparatuses 2 and 4 are provided to have a shape slightly larger than the substrate 10, so that the infrared radiation apparatuses 2 and 4 include the entire substrate 10 in plan view when the substrate 10 is conveyed along the substrate conveyance path circle M2.

The thin film forming nozzles 1L and 1H being first and second direction mist spraying units are attached inside each of the film forming chambers F21 and F22, in a similar manner to the thin film forming nozzles 1L and 1H of the first embodiment attached inside the film forming chamber F10. Note that the film forming chambers F21 and F22 are provided without an opening area that connects to the outside, except a rotation side surface opening area to be described later.

In the film forming apparatus 72 of the second embodiment having such a configuration, a plurality of substrates 10 (sixteen substrates 10 in FIG. 3) are conveyed along the substrate conveyance path circle M2 in the substrate rotation direction R2 by the substrate conveying apparatus 8.

Then, after the first heating treatment of the infrared radiation apparatuses 2 and 4 (heating mechanism) in the heating chamber H21 is performed, the first mist spraying treatment of the thin film forming nozzles 1L and 1H (mist spraying unit) in the film forming chamber F21 is performed. Further, after the second heating treatment of the infrared radiation apparatuses 2 and 4 in the heating chamber H22 is performed, the second mist spraying treatment of the thin film forming nozzles 1L and 1H in the film forming chamber F22 is performed. As a result, a thin film can be formed on each of a front surface and a back surface of the plurality of substrates 10.

Therefore, the film forming apparatus 72 of the second embodiment produces effects similar to those of the film forming apparatus 71 of the first embodiment. Effects specific to the second embodiment will be described below.

In the film forming apparatus 72 of the second embodiment, when the infrared radiation apparatuses 2 and 4 provided in each of the heating chambers H21 and H22 are collectively regarded as one unit of heating mechanisms, a plurality of heating mechanisms (two units of heating mechanisms) are disposed in a corresponding heating chamber out of a plurality of heating chambers (two heating chambers H21 and H22).

Similarly, when the thin film forming nozzles 1L and 1H provided in each of the film forming chambers F21 and F22 are regarded as one unit of mist spraying units, a plurality of mist spraying units (two units of mist spraying units) are disposed in a corresponding film forming chamber out of a plurality of film forming chambers (two film forming chambers F21 and F22).

Therefore, when the film forming apparatus 72 of the second embodiment conveys one substrate 10 along the substrate conveyance path circle M2 with the substrate rotation direction R2 being a moving direction and a point inside the heating chamber H21 being a start point, the film forming apparatus 72 of the second embodiment performs the following treatment in one rotation, in the order of the first heating treatment in the heating chamber H21, the first mist spraying treatment in the film forming chamber F21, the second heating treatment in the heating chamber H22, and the second mist spraying treatment in the film forming chamber F22.

Specifically, when the substrate 10 makes one rotation along the substrate conveyance path circle M2, the film forming apparatus 72 of the second embodiment performs heating treatment twice (first and second heating treatments) and mist spraying treatment twice (first and second mist spraying treatments).

As described above, the film forming apparatus 72 of the second embodiment can enhance throughput of film forming treatment, since the number of times of film forming treatments (heating treatment + mist spraying treatment) for one substrate 10 per rotation can be increased when the substrate 10 is conveyed to be rotated along the substrate conveyance path circle M2 (predetermined circle).

### <Third Embodiment>

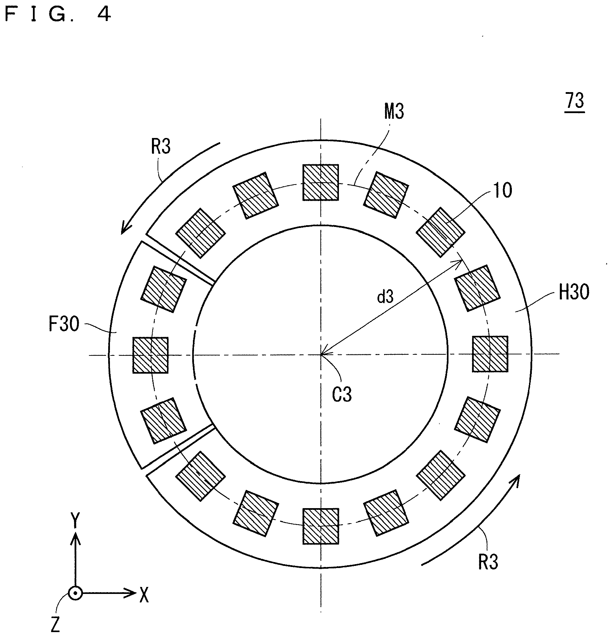

FIG. 4 is an explanatory diagram schematically illustrating a plan structure of a film forming apparatus 73 being a third embodiment of the present invention. An XYZ orthogonal coordinate system is illustrated in FIG. 4. In the following, features specific to the film forming apparatus 73 of the third embodiment will be mainly described, and description of features similar to those of the film forming apparatus 71 of the first embodiment will be omitted as appropriate.

As illustrated in FIG. 4, a substrate conveyance path circle M3 (predetermined circle) being a circle having a radius d3 and a center point C3 as its center is set.

Each of a heating chamber H30 and a film forming chamber F30 is disposed separately from each other along the substrate conveyance path circle M3 in an arc shape. The heating chamber H30 and the film forming chamber F30 are disposed adjacently to each other, and are provided not to have a substantial empty space on the substrate conveyance path circle M3.

With a substrate conveying apparatus 8 to be described later in detail, a plurality of substrates 10 are simultaneously conveyed along the substrate conveyance path circle M3, with a substrate rotation direction R3 being a moving direction.

The infrared radiation apparatuses 2 and 4 being first and second direction heating units are attached inside the heating chamber H30, in a similar manner to the infrared radiation apparatuses 2 and 4 of the first embodiment attached inside the heating chamber H10. The heating chamber H30 is provided without an opening area that connects to the outside, except a rotation side surface opening area to be described later.

Note that a plurality of infrared radiation apparatuses 2 and 4 are disposed in a distributed manner in a rectangular shape in plan view in the heating chamber H30. For example, a plurality of infrared radiation apparatuses 2 and 4 are disposed in a distributed manner at positions corresponding to a plurality of substrates 10 illustrated in FIG. 4. Further, the infrared radiation apparatuses 2 and 4 are provided to have a shape slightly larger than the substrate 10, so that the infrared radiation apparatuses 2 and 4 include the entire substrate 10 in plan view when the substrate 10 is conveyed along the substrate conveyance path circle M3.

The thin film forming nozzles 1L and 1H being first and second direction mist spraying units are attached inside the film forming chamber F30, in a similar manner to the thin film forming nozzles 1L and 1H of the first embodiment attached inside the film forming chamber F10. Note that the film forming chamber F30 is provided without an opening area that connects to the outside, except a rotation side surface opening area to be described later.

Note that a plurality of thin film forming nozzles 1L and 1H are disposed in a distributed manner in a rectangular shape in plan view in the film forming chamber F30. For example, three thin film forming nozzles 1L and 1H are disposed in a distributed manner at positions corresponding to three substrates 10 illustrated in FIG. 4.

As described above, although a plurality of (three) thin film forming nozzles 1L and 1H are provided in a distributed manner in the film forming chamber F30, only a pair of thin film forming nozzles 1L and 1H will be described below for the sake of convenience in description.

In the film forming apparatus 73 of the third embodiment having such a configuration, a plurality of substrates 10 (sixteen substrates 10 in FIG. 4) are conveyed along the substrate conveyance path circle M3 with the substrate rotation direction R3 being a moving direction, by the substrate conveying apparatus 8.

Then, after the heating treatment of the infrared radiation apparatuses 2 and 4 (heating mechanism) is performed, the mist spraying treatment of the thin film forming nozzles 1L and 1H (mist spraying unit) is performed. In this manner, a thin film is formed on each of a front surface and a back surface of the plurality of substrates 10.

Therefore, the film forming apparatus 73 of the third embodiment produces effects similar to those of the film forming apparatus 71 of the first embodiment. Features of the third embodiment and effects of such features will be described below.

Here, one case is considered. That case is one where necessary heating time TH3 is required to perform the heating treatment of the infrared radiation apparatuses 2 and 4 in the heating chamber H30, and necessary mist spraying time TM3 is required to perform the mist spraying treatment of the thin film forming nozzles 1L and 1H in the film forming chamber F30. Specifically, the considered case is one where a desired thin film can be formed with high quality, by performing the heating treatment of the necessary heating time TH3, and then performing the mist spraying treatment of the necessary mist spraying time TM3.

In this case, a necessary time ratio PT3, which is a ratio of the necessary heating time TH3 to the necessary mist spraying time TM3, is calculated by "PT3 = TM3/TH3."

Here, a process length ratio PL3, which is a ratio of a heating process length LH3 to a film forming process length LM3, is "PL3 = LM3/LH3," where LH3 represents a heating process length of an arc-shaped formation length along the substrate conveyance path circle M3 of the heating chamber H30, and LM3 represents a film forming process length of an arc-shaped formation length along the substrate conveyance path circle M3 of the film forming chamber F30.

The film forming apparatus 73 of the third embodiment has a feature in that the process length ratio PL3 is designed to match the necessary time ratio PT3. Specifically, designing is carried out to substantially satisfy "PL3 = PT3."

For example, when the necessary time ratio PT3 is 3/13, the heating process length LH3 and the film forming process length LM3 are formed such that the process length ratio PL3 is 3/13. For example, as illustrated in FIG. 4, the heating chamber H30 has such a heating process length LH3 as to enable simultaneous accommodation of thirteen substrates 10 at regular intervals, and the film forming chamber F30 has such a film forming process length LM3 as to enable simultaneous accommodation of three substrates 10 at regular intervals.

As described above, the film forming apparatus 73 of the third embodiment sets the process length ratio PL3, which is a ratio of the heating process length LH3 to the film forming process length LM3, such that the process length ratio PL3 matches the necessary time ratio PT3, which is a ratio of the necessary heating time TH3 to the necessary mist spraying time TM3.

V3 is used to represent a conveying speed with the substrate conveying apparatus 8 along the substrate conveyance path circle M3 in the substrate rotation direction R3. Then, a conveying speed V3 that satisfies condition (1) {TH3 = LH3/V3} is calculated. V3H is used to represent a conveying speed of the conveying speed V3 in this case.

Next, a conveying speed V3 that satisfies condition (2) "TM3 = LM3/V3" is calculated. V3M is used to represent a conveying speed of the conveying speed V3 in this case.

In the film forming apparatus 73 of the third embodiment, as described above, the process length ratio PL3 and the necessary time ratio PT3 are equal. Such equation yields an equation of {V3M (= LM3/TM3 = (PL3·LH3)/(PT3·TH3) = LH3/TH3) = V3H}, thus equalizing the conveying speed V3H and the conveying speed V3M.

As a result, the film forming apparatus 73 of the third embodiment can produce an effect of enabling easier performance of operation control of the substrate conveying apparatus 8, since the conveying speed V3 of the substrate 10 with the substrate conveying apparatus 8 can be determined to an optimal constant value (V3H (= V3M)).

Further, as illustrated in FIG. 4, the film forming process length LM3 of the film forming chamber F30 is increased to enable simultaneous accommodation of three substrates 10, which produces another effect of enabling securing the necessary mist spraying time TM3 that is sufficient even when the conveying speed V3 is increased.

### (Modification)

Note that, when the number of substrates 10 is one, one mode of a case where the process length ratio PL3 does not match the necessary time ratio PT3 is conceived as a modification of the third embodiment. In the modification, the conveying speed V3 with the substrate conveying apparatus 8 is determined as follows.

First, a conveying speed V3 that satisfies condition (1) described above is determined (provisionally "V3H"). Next, a conveying speed V3 that satisfies condition (2) described above is determined (provisionally "V3M"). The conveying speed V3H and the conveying speed V3M do not match.

Therefore, in the modification of the third embodiment, the conveying speed V3 of the substrate 10 with the substrate conveying apparatus 8 is set to the conveying speed V3H in the heating chamber H30 and the conveying speed V3M in the film forming chamber F30. In this manner the conveying speed V3 is individually set in the heating chamber H30 and the film forming chamber F30.

As described above, the modification of the third embodiment that can be applied to a case where the number of substrates 10 is one has the following feature. Specifically, regarding the conveying speed V3 of the substrate 10 with the substrate conveying apparatus 8, the conveying speed V3H in the heating chamber H30 and the conveying speed V3H in the film forming chamber F30 are individually set based on the heating process length LH3 and the film forming process length LM3, such that each of the necessary heating time TH3 and the necessary mist spraying time TM3 is satisfied.

Since the modification of the third embodiment has the above feature, film forming treatment for one substrate 10 can be performed under an optimal condition that satisfies condition (1) and condition (2) described above.

Note that, instead of condition (1) and condition (2) described above, condition (3) {TH3 = N·(LH3/V3)} and condition (4) {TM3 = N·(LM3/V3)} may be used. Note that N represents the number of times of rotation on the substrate conveyance path circle M3. The number of times of rotation N is the same in the heating treatment and the mist spraying treatment.

Note that, when objects to be simultaneously subjected to film formation is one substrate 10, the modification of the third embodiment can also be applied to the film forming apparatus 71 of the first embodiment and the film forming apparatus 72 of the second embodiment, as well as to the film forming apparatus 73 of the third embodiment.

### <Fourth Embodiment>

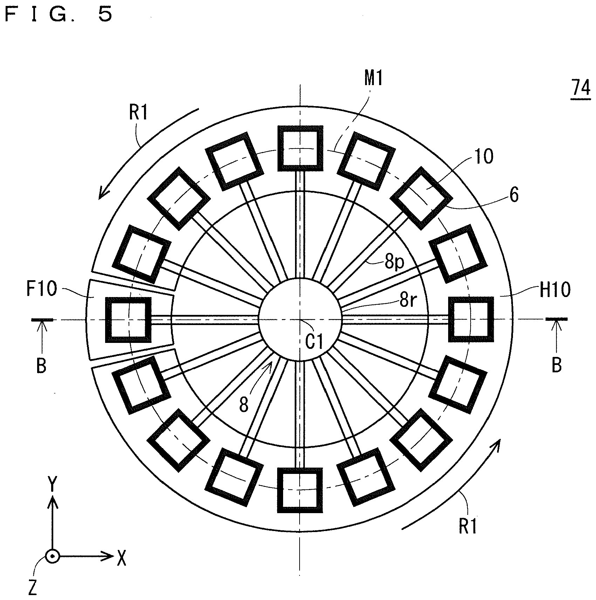

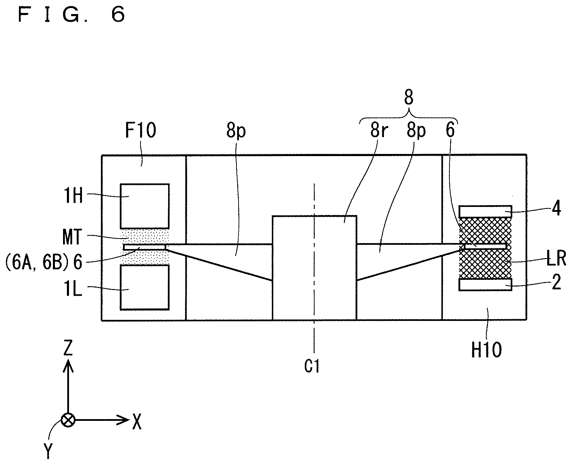

FIG. 5 is an explanatory diagram schematically illustrating a plan structure of a film forming apparatus 74 being a fourth embodiment of the present invention. FIG. 6 is a cross-sectional view illustrating a cross-sectional structure of the film forming apparatus 74 of the fourth embodiment. FIG. 6 illustrates a cross-section taken along the line B-B of FIG. 5. An XYZ orthogonal coordinate system is illustrated in each of FIG. 5 and FIG. 6. The film forming apparatus 74 of the fourth embodiment has the same configuration as the configuration of the film forming apparatus 71 of the first embodiment, except that the substrate conveying apparatus 8 is specifically illustrated. Note that, in FIG. 6, illustration of the lamp placing table 31 and the infrared lamp 32 of the infrared radiation apparatus 2 and the lamp placing table 41 and the infrared lamp 42 of the infrared radiation apparatus 4 is omitted.

The substrate conveying apparatus 8 will be described below. The substrate conveying apparatus 8 includes, as its main components, a rotation main body 8r, rotation auxiliary members 8p, and substrate holders 6. The rotation main body 8r and the rotation auxiliary members 8p constitute a rotation mechanism unit.

As illustrated in FIG. 5 and FIG. 6, the rotation main body 8r has a cylindrical shape, and performs rotational operation along the substrate rotation direction R1 about the center point C1. Specifically, the rotation main body 8r performs rotational operation for conveying a plurality of substrates 10 along the substrate conveyance path circle M1 (predetermined circle). Note that examples of a drive source of the rotation main body 8r include a motor.

From a side surface of the rotation main body 8r, a plurality of rotation auxiliary members 8p are provided to radially extend in a radial direction about the center point C1. Therefore, the plurality of rotation auxiliary members 8p are rotated in the substrate rotation direction R1 along with rotational operation of the rotation main body 8r.

Further, the substrate holder 6 is provided to be coupled to a tip end portion of each of the plurality of rotation auxiliary members 8p. Specifically, a plurality of substrate holders 6 are provided corresponding to the plurality of rotation auxiliary members 8p. The substrate holder 6 holds the substrate 10, and is conveyed on the substrate conveyance path circle M1 together with the substrate 10 along with rotational operation of the rotation mechanism unit (rotation main body 8r + rotation auxiliary member 8p).

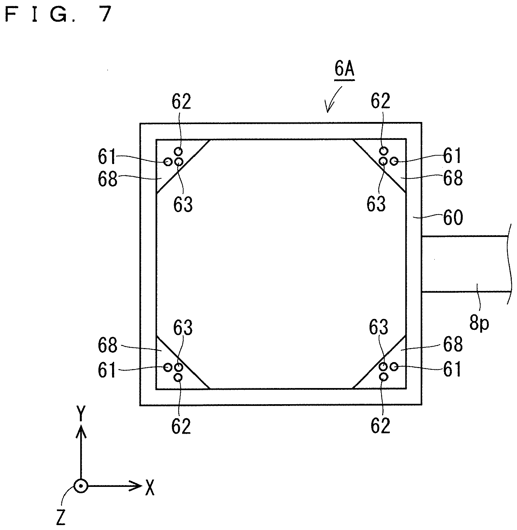

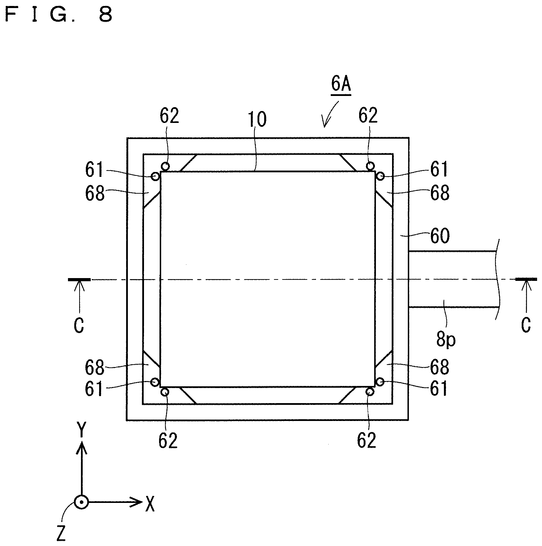

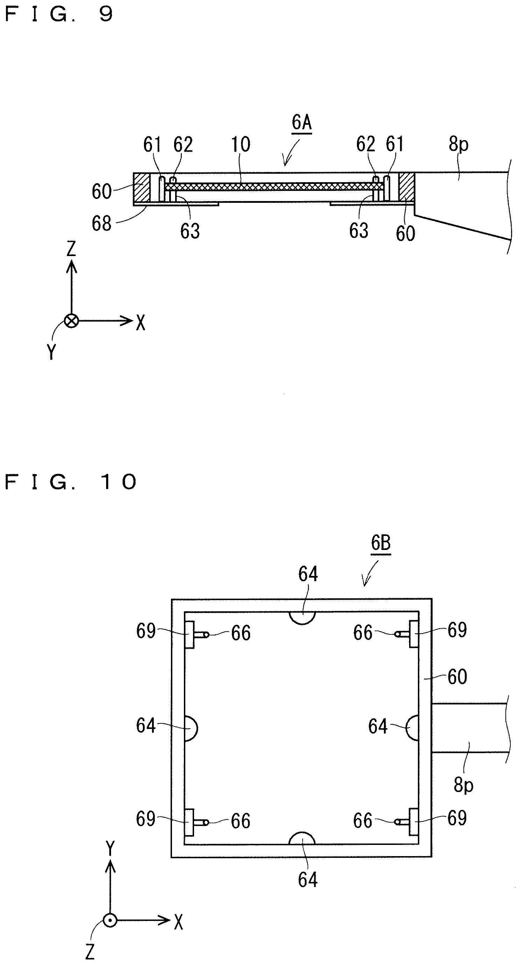

FIG. 7 and FIG. 8 are each a plan view illustrating a plan structure of a substrate holder 6A being a first aspect of the substrate holder 6. FIG. 7 illustrates a state before the substrate 10 is held. FIG. 10 illustrates a state in which the substrate 10 is held. FIG. 9 is a cross-sectional view illustrating a cross-sectional structure taken along the line C-C of FIG. 8. An XYZ orthogonal coordinate system is illustrated in each of FIG. 7 to FIG. 9.

As illustrated in FIG. 7 to FIG. 9, the substrate holder 6A includes, as its main components, a substrate frame structure 60, substrate guide members 61 to 63, and pin support tables 68.

The substrate frame structure 60 is a frame structure that has a substantially rectangular spatial area in its inside. The spatial area has an area slightly larger than a formation area of the substrate 10. The pin support tables 68 each having a shape of a right triangle in plan view are provided at four corner portions of the spatial area. The substrate guide members 61 to 63 are provided on each of the four pin support tables 68.

The substrate guide members 61 and 62 are provided on the pin support table 68 at the same height. The substrate guide member 61 is provided for positioning in the X direction. The substrate guide member 62 is provided for positioning in the Y direction. Specifically, the substrate guide members 61 and 62 are provided such that a distance between the substrate guide members 61 and 61 facing in the X direction is substantially equal to the length of the substrate 10 in the X direction, and that a distance between the substrate guide members 62 and 62 facing in the Y direction is substantially equal to the length of the substrate 10 in the Y direction.

The substrate guide member 63 is provided such that a formation position in the X direction matches that of the substrate guide member 62, and that a formation position in the Y direction matches that of the substrate guide member 61, and is provided on the pin support table 68. As illustrated in FIG. 9, a formation height of the substrate guide member 63 is set to be lower than that of the substrate guide members 61 and 62.

As illustrated in FIG. 8 and FIG. 9, the substrate holder 6A allows the substrates 10 to be placed on four substrate guide members 63. Specifically, four substrate guide members 63 support four corner portions of a back surface of the substrate 10 from a back surface side.

In this case, positioning in the X direction is performed by disposing the substrate 10 between two pairs of substrate guide members 61 and 61 facing in the X direction. Positioning in the Y direction is performed by disposing the substrate 10 between two pairs of substrate guide members 62 and 62 facing in the Y direction.

As described above, the substrate holder 6A can hold the substrate 10, owing to positioning in the X direction with four substrate guide members 61, positioning in the Y direction with four substrate guide members 62, and support of the substrate 10 with four substrate guide members 63.

Further, both of the positioning in the X direction with four substrate guide members 61 and the positioning in the Y direction with four substrate guide members 62 are performed in a manner of sandwiching the substrate 10 having a rectangular shape in plan view. Therefore, a holding function of the substrate 10 is reinforced.

As described above, the substrate 10 held by the substrate holder 6A of the first aspect is positioned so that the center of the substrate 10 is located on the substrate conveyance path circle M1.

Therefore, the substrate holder 6A holds the substrate 10 while the entire front surface and the entire back surface, except corner portions, of the substrate 10 are exposed. Specifically, in the back surface of the substrate 10 having a rectangular shape in plan view, the entire area is exposed, except for areas at four corner portions that come in contact with tip end portions of four substrate guide members 63.

As described above, the substrate holder 6A holds the substrate 10, and is conveyed on the substrate conveyance path circle M1 together with the substrate 10 along with rotational operation of the rotation main body 8r.

As described above, in the first aspect of the substrate conveying apparatus 8 including the rotation main body 8r, the rotation auxiliary members 8p, and the substrate holders 6A as its main components, the rotation main body 8r can be caused to perform rotational operation along the substrate rotation direction R1 by using a motor or the like as its drive source. Therefore, the substrate conveying apparatus 8 can be implemented with relatively low costs.

Further, the substrate holder 6A holds the substrate 10 while the entire front surface and the entire back surface, except corner portions, of the substrate 10 are exposed. Therefore, a thin film can be formed without hindering the heating treatment of the heating mechanism (infrared radiation apparatuses 2 and 4) and the mist spraying treatment of the mist spraying unit (thin film forming nozzles 1L and 1H).

Note that tip end areas of the rotation auxiliary members 8p and the substrate holders 6 are disposed in the heating chamber H10 and the film forming chamber F10. Therefore, to stably perform rotational operation of the rotation main body 8r, a rotation side surface opening area (not shown) is provided on an inner side surface of the heating chamber H10 and the film forming chamber F10. Tip end portions of the rotation auxiliary members 8p can be disposed inside the heating chamber H10 and the film forming chamber F10, through the rotation side surface opening area.

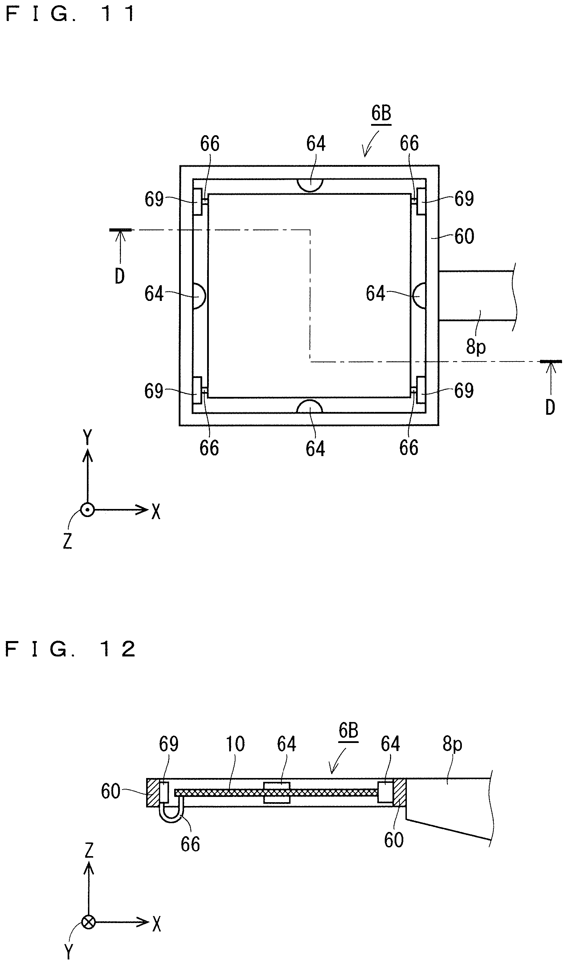

FIG. 10 and FIG. 11 are each a plan view illustrating a plan structure of a substrate holder 6B being a second aspect of the substrate holder 6. FIG. 10 illustrates a state before the substrate 10 is held. FIG. 11 illustrates a state in which the substrate 10 is held. FIG. 12 is a cross-sectional view illustrating a cross-sectional structure taken along the line D-D of FIG. 11. An XYZ orthogonal coordinate system is illustrated in each of FIG. 10 to FIG. 12.

As illustrated in FIG. 11, the substrate holder 6B includes, as its main components, a substrate frame structure 60, substrate guide members 64, substrate lift pins 66, and pin attachment tables 69.

The substrate frame structure 60 is a frame structure that has a substantially rectangular spatial area in its inside. The spatial area has an area slightly larger than a formation area of the substrate 10. The substrate guide member 64 is provided at a center portion of each of four inner side surfaces of the substrate frame structure 60 that defines the spatial area. Each of the four substrate guide members 64 has a semicircular shape in plan view. The four substrate guide members 64 are provided on inner side surfaces of the substrate frame structure 60 such that a round portion of the semicircular shape corresponds to the X direction or the Y direction.

Regarding four pin attachment tables 69, two pin attachment tables 69 are provided on respective two inner side surfaces of the substrate frame structure 60 extending in the Y direction, such that a total of four pin attachment tables 69 are provided. Two pin attachment tables 69 are provided near both end portions of two inner side surfaces extending in the Y direction.

The substrate lift pin 66 having a substantially U-like shape in cross-sectional view is provided from a bottom surface of each pin attachment table 69. Specifically, four substrate lift pins 66 are provided corresponding to four pin attachment tables 69. Four substrate lift pins 66 are disposed such that four substrate lift pins 66 are located slightly on the inner side with respect to four top points of the substrate 10 when tip end portions of four substrate lift pins 66 hold the substrate 10.

Two substrate guide members 64 facing in the X direction out of four substrate guide members 64 are provided for positioning of the substrate 10 in the X direction. Two substrate guide members 64 facing in the Y direction out of four substrate guide members 64 are provided for positioning of the substrate 10 in the Y direction.

Specifically, the substrate guide members 64 and 64 are provided such that a distance between the substrate guide members 64 and 64 facing in the X direction is substantially equal to the length of the substrate 10 in the X direction, and that a distance between the substrate guide members 64 and 64 facing in the Y direction is substantially equal to the length of the substrate 10 in the Y direction.

As illustrated in FIG. 11 and FIG. 12, the substrate holder 6B allows the substrates 10 to be placed on tip end portions of four substrate lift pins 66. Specifically, four substrate lift pins 66 support four corner portions of a back surface of the substrate 10 from a back surface side.

In this case, positioning in the X direction is performed by disposition between a pair of substrate guide members 64 and 64 facing in the X direction. Positioning in the Y direction is performed by disposition between a pair of substrate guide members 64 and 64 facing in the Y direction.

As described above, the substrate holder 6B can hold the substrate 10, owing to positioning of the substrate 10 in the X direction and the Y direction with four substrate guide members 64, and support of the substrate 10 with four substrate lift pins 66.

Further, the positioning in the X direction and the Y direction with four substrate guide members 64 are performed in a manner of sandwiching the substrate 10 having a rectangular shape in plan view. Therefore, a holding function of the substrate 10 is reinforced.

As described above, the substrate 10 held by the substrate holder 6B of the second aspect is positioned so that the center of the substrate 10 is located on the substrate conveyance path circle M1.

Therefore, the substrate holder 6B holds the substrate 10 while the entire front surface and the entire back surface, except corner portions, of the substrate 10 are exposed. Specifically, in the back surface of the substrate 10 having a rectangular shape in plan view, the entire area is exposed, except for areas at four corner portions that come in contact with tip end portions of four substrate lift pins 66.

As described above, the substrate holder 6B holds the substrate 10, and is conveyed on the substrate conveyance path circle M1 together with the substrate 10 along with rotational operation of the rotation main body 8r.

As described above, in the second aspect of the substrate conveying apparatus 8 including the rotation main body 8r, the rotation auxiliary members 8p, and the substrate holders 6B as its main components, the rotation main body 8r can be caused to perform rotational operation along the substrate rotation direction R1 by using a motor or the like as its drive source. Therefore, the substrate conveying apparatus 8 can be implemented with relatively low costs.

Further, the substrate holder 6B holds the substrate 10 while the entire front surface and the entire back surface, except corner portions, of the substrate 10 are exposed. Therefore, a thin film can be formed without hindering the heating treatment of the heating mechanism (infrared radiation apparatuses 2 and 4) and the mist spraying treatment of the mist spraying unit (thin film forming nozzles 1L and 1H).

Note that the fourth embodiment illustrates a configuration of using the substrate conveying apparatus 8 as a substrate conveying unit of the film forming apparatus 71 of the first embodiment. However, as a matter of course, the substrate conveying apparatus 8 can be used as a substrate conveying unit of the film forming apparatus 72 and the film forming apparatus 73 of the second embodiment and the third embodiment.

In this case, the rotation side surface opening area (not shown) is provided on an inner side surface of the heating chambers H21 and H22, the film forming chambers F21 and F22, the heating chamber H30, and the film forming chamber F30. In this manner, tip end portions of the rotation auxiliary members 8p can be disposed inside the heating chambers H21 and H22, the film forming chambers F21 and F22, the heating chamber H30, and the film forming chamber F30, through the rotation side surface opening area.

### <Fifth Embodiment>

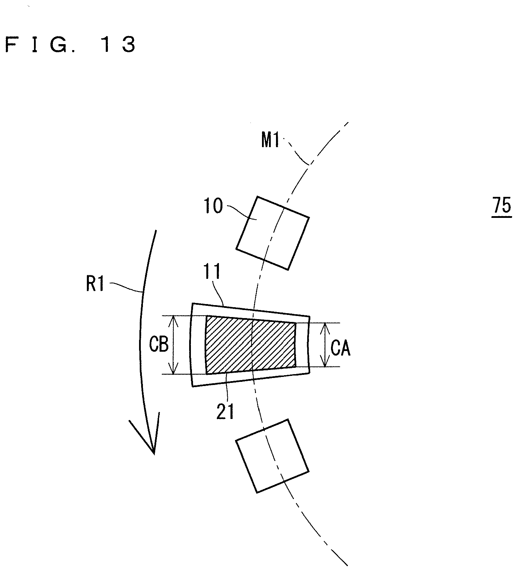

FIG. 13 is an explanatory diagram schematically illustrating a plan structure of a thin film forming nozzle 11 in a film forming apparatus 75 being a fifth embodiment of the present invention. The film forming apparatus 75 of the fifth embodiment has the same configuration as the configuration of the film forming apparatus 71 of the first embodiment, except that the thin film forming nozzles 1L and 1H are replaced by the thin film forming nozzle 11.

The thin film forming nozzle 11 used in the fifth embodiment will be described below. Note that the thin film forming nozzle 11 is used instead of each of the thin film forming nozzles 1L and 1H illustrated in FIG. 2, and sprays the source mist MT from a mist spray port 21.

Therefore, when the thin film forming nozzle 11 is used as the thin film forming nozzle 1L, the thin film forming nozzle 11 is provided on a lower side of the substrate 10, and sprays the source mist MT along a first direction, which is a direction toward the upper side from the mist spray port 21. In contrast, when the thin film forming nozzle 11 is used as the thin film forming nozzle 1H, the thin film forming nozzle 11 is provided on an upper side of the substrate 10, and sprays the source mist MT along a second direction, which is a direction toward the lower side from the mist spray port 21.

As illustrated in FIG 13, the thin film forming nozzle 11 includes the mist spray port 21 that sprays the source mist MT. The mist spray port 21 has an opening area having an arc length CA on an inner side (side close to the center point C1 (see FIG. 1)) smaller than an arc length CB on an outer side (side away from the center point C1) (CA < CB).

Specifically, the mist spray port 21 has a feature in having such a shape that an opening area is wider on a side farther from the center point C1 of the substrate conveyance path circle M1 (predetermined circle).

Since the mist spray port 21 of the thin film forming nozzle 11 being a mist spraying unit of the film forming apparatus 75 of the fifth embodiment has the above feature, the source mist can be sprayed uniformly onto the substrate 10, irrespective of the distance from the center point C1 of the substrate conveyance path circle M1 (predetermined circle).

### (First Modification)

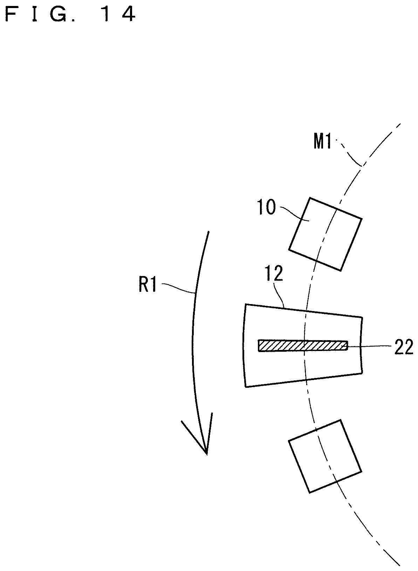

FIG. 14 is an explanatory diagram schematically illustrating a plan structure of a thin film forming nozzle 12 being a first modification of the film forming apparatus 75 of the fifth embodiment. Similarly to the thin film forming nozzle 11, the thin film forming nozzle 12 is used instead of each of the thin film forming nozzles 1L and 1H illustrated in FIG. 2, and sprays the source mist MT from a mist spray port 22.

As illustrated in FIG. 14, the thin film forming nozzle 12 is provided such that a formation width (formation length along a tangential direction of the substrate conveyance path circle M1) of the mist spray port 22 that sprays the source mist MT is sufficiently narrow. Note that an appropriate range of the formation width of the mist spray port 22 is 1 mm or more and 5 mm or less. Specifically, the formation width of the mist spray port 22 is desirably 2 mm.

The first modification of the fifth embodiment has a feature in that the formation width of the mist spray port 22 has a sufficiently narrow shape.

Since the mist spray port 22 of the thin film forming nozzle 12 being a mist spraying unit has the above feature, the source mist can be sprayed uniformly onto the substrate 10, irrespective of the distance from the center point C1 of the substrate conveyance path circle M1 (predetermined circle).

### (Second Modification)

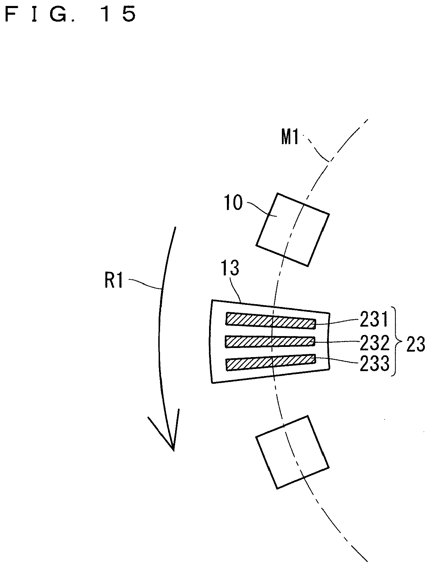

FIG. 15 is an explanatory diagram illustrating a plan structure of a thin film forming nozzle 13 being a second modification of the film forming apparatus 75 of the fifth embodiment. Similarly to the thin film forming nozzle 11, the thin film forming nozzle 13 is used instead of each of the thin film forming nozzles 1L and 1H illustrated in FIG. 2, and sprays the source mist MT from a mist spray port 23.

As illustrated in FIG. 15, in the thin film forming nozzle 13, the mist spray port 23 that sprays the source mist MT consists of three mist spray ports 231 to 233 that are disposed in a distributed manner so as to be apart from each other. The mist spray ports 231 to 233 are provided such that a formation width (formation length along a tangential direction of the substrate conveyance path circle M1) of each of the mist spray ports 231 to 233 is sufficiently narrow. Note that an appropriate range of the formation width of each of the mist spray ports 231 to 233 is 1 mm or more and 5 mm or less. Specifically, the formation width of each of the mist spray ports 231 to 233 is desirably 2 mm.

The second modification of the fifth embodiment has a feature in that the formation width of each of the mist spray ports 231 to 233 of the mist spray port 23 has a sufficiently narrow shape.

Since the mist spray port 23 of the thin film forming nozzle 13 being a mist spraying unit has the above feature, the source mist can be sprayed uniformly onto the substrate 10, irrespective of the distance from the center point C1 of the substrate conveyance path circle M1 (predetermined circle).

Further, since the second modification includes three mist spray ports 231 to 233, a spray amount of the source mist MT is not reduced.

Note that the fifth embodiment illustrates an example in which the thin film forming nozzles 11 to 13 are used as a mist spraying unit of the film forming apparatus 71 of the first embodiment (including the film forming apparatus 74 of the fourth embodiment). However, as a matter of course, the thin film forming nozzles 11 to 13 can be used as a mist spraying unit of the film forming apparatus 72 and the film forming apparatus 73 of the second embodiment and the third embodiment.

While the invention has been shown and described in detail, the foregoing description is in all aspects illustrative and not restrictive. It is therefore understood that numerous unillustrated modifications and variations can be devised without departing from the scope of the invention.

Therefore, in the present invention, each embodiment can be freely combined, and each embodiment can be modified or omitted as appropriate, within the scope of the invention.

### Explanation of Reference Signs

1H, 1L, 11-13 Thin film forming nozzle
2, 4 Infrared radiation apparatus
6, 6A, 6B Substrate holder
8 Substrate conveying apparatus
10 Substrate
21-23, 231-233 Mist spray port
71-75 Film forming apparatus
F10, F21, F22, F30 Film forming chamber
H10, H21, H22, H30 Heating chamber

## Claims

1. A film forming apparatus comprising:
a substrate conveying unit (8) configured to convey a substrate (10) along a predetermined circle;
a heating mechanism (2, 4) provided in a heating chamber (H10, H21, H22, H30) disposed along said predetermined circle, said heating mechanism being configured to perform heating treatment of heating said substrate without touching said substrate in said heating chamber; and
a mist spraying unit (1H, 1L) provided in a film forming chamber (F10, F21, F22, F30) disposed along said predetermined circle, said mist spraying unit being configured to perform mist spraying treatment of spraying source mist (MT) toward said substrate in said film forming chamber, said source mist being obtained by atomizing a source solution, wherein
said heating chamber and said film forming chamber are disposed separately from each other, and said substrate is conveyed along said predetermined circle by said substrate conveying unit to form a thin film on said substrate by performing said heating treatment of said heating mechanism in said heating chamber and then performing said mist spraying treatment of said mist spraying unit in said film forming chamber .

2. The film forming apparatus according to claim 1, wherein
said substrate includes a plurality of substrates.

3. The film forming apparatus according to claim 1 or 2, wherein
said heating chamber includes a plurality of heating chambers (H21, H22), said heating mechanism includes a plurality of heating mechanisms, and said plurality of heating mechanisms are disposed in a corresponding heating chamber out of said plurality of heating chambers, and
said film forming chamber includes a plurality of film forming chambers (F21, F22), said mist spraying unit includes a plurality of mist spraying units, and said plurality of mist spraying units are disposed in a corresponding film forming chamber out of said plurality of film forming chambers.

4. The film forming apparatus according to any one of claims 1 to 3, wherein said heating chamber (H30) has a heating process length (LH3) along said predetermined circle, said film forming chamber (F30) has a film forming process length (LM3) along said predetermined circle, necessary heating time (TH3) is required to perform said heating treatment, and necessary mist spraying time (TM3) is required to perform said mist spraying treatment, and
a process length ratio (PL3) being a ratio of said heating process length to said film forming process length is set to match a necessary time ratio (PT3) being a ratio of said necessary heating time to said necessary mist spraying time.

5. The film forming apparatus according to claim 1, wherein
said substrate includes one substrate,
said heating chamber (H30) has a heating process length (LH3) along said predetermined circle, said film forming chamber has a film forming process length (LM3) along said predetermined circle, necessary heating time (TH3) is required to perform said heating treatment, and necessary mist spraying time (TM3) is required to perform said mist spraying treatment, and
regarding a conveying speed (V3) of said substrate along said predetermined circle with said substrate conveying unit, a conveying speed (V3H) in said heating chamber and a conveying speed (V3M) in said film forming chamber are individually set based on said heating process length and said film forming process length, such that both of said necessary heating time and said necessary mist spraying time are satisfied.

6. The film forming apparatus according to any one of claims 1 to 3, wherein said mist spraying unit includes a mist spray port (21-23) configured to spray said source mist, and
said mist spray port has a shape that an opening area is wider on a side farther from a center point of said predetermined circle.

7. The film forming apparatus according to any one of claims 1 to 3, wherein said substrate conveying unit includes:
a rotation mechanism unit (8r, 8p) configured to perform rotational operation for conveying said substrate along said predetermined circle; and
a substrate holder (6, 6A, 6B) configured to hold said substrate, and configured to be conveyed along said predetermined circle along with said rotational operation.

8. The film forming apparatus according to claim 7, wherein
said substrate is a substrate having a rectangular shape in plan view, and
said substrate holder holds said substrate while an entire front surface of said substrate is exposed and an entire back surface of said substrate except a corner portion is exposed.

9. The film forming apparatus according to any one of claims 1 to 3, wherein said heating mechanism includes:
a first direction heating unit (2) configured to perform first direction heating treatment of heating said substrate by radiating infrared light toward a first direction; and
a second direction heating unit (4) configured to perform second direction heating treatment of heating said substrate by radiating infrared light toward a second direction, said second direction being a direction opposite to said first direction, wherein
said heating treatment includes said first direction heating treatment and said second direction heating treatment, said first direction is a direction from a back surface to a front surface of said substrate, and said second direction is a direction from the front surface to the back surface of said substrate.

10. The film forming apparatus according to claim 9, wherein
said mist spraying unit includes:
a first direction mist spraying unit (1L) configured to perform first direction mist spraying treatment of spraying said source mist toward said first direction; and
a second direction mist spraying unit (1H) configured to perform second direction mist spraying treatment of spraying said source mist toward said second direction, wherein
said mist spraying treatment includes said first direction mist spraying treatment and said second direction mist spraying treatment.

## Patentansprüche

1. Filmbildungsvorrichtung mit:
einer Substrattransportvorrichtung (8), die dazu ausgelegt ist, ein Substrat (10) entlang eines vorbestimmten Kreises zu transportieren;
einem Heizmechanismus (2, 4), der in einer Heizkammer (H10, H21, H22, H30) vorgesehen ist, die entlang des vorbestimmten Kreises angeordnet ist, wobei der Heizmechanismus dazu ausgelegt ist, eine Heizbehandlung zum Erhitzen des Substrats durchzuführen, ohne das Substrat in der Heizkammer zu berühren; und
einer Nebelsprüheinheit (1H, 1L), die in einer Filmbildungskammer (F10, F21, F22, F30) vorgesehen ist, die entlang des vorbestimmten Kreises angeordnet ist, wobei die Nebelsprüheinheit dazu konfiguriert ist, eine Nebelsprühbehandlung zum Sprühen von Quellnebel (MT) in Richtung des Substrats in der Filmbildungskammer durchzuführen, wobei der Quellnebel durch Zerstäuben einer Quelllösung erhalten wird, wobei
die Heizkammer und die Filmbildungskammer getrennt voneinander angeordnet sind und das Substrat entlang des vorbestimmten Kreises mittels der Substrattransporteinheit transportiert wird, um einen dünnen Film auf dem Substrat zu bilden, indem die Heizbehandlung des Heizmechanismus in der Heizkammer und dann die Nebelsprühbehandlung der Nebelsprüheinheit in der Filmbildungskammer durchgeführt wird.

2. Filmbildungsvorrichtung nach Anspruch 1, wobei das Substrat eine Mehrzahl von Substraten aufweist.

3. Filmbildungsvorrichtung nach Anspruch 1 oder 2, wobei
die Heizkammer eine Mehrzahl von Heizkammern (H21, H22) beinhaltet, der Heizmechanismus eine Mehrzahl von Heizmechanismen beinhaltet, und die Mehrzahl von Heizmechanismen in einer entsprechenden Heizkammer aus der Mehrzahl von Heizkammern angeordnet sind, und
die Filmbildungskammer eine Mehrzahl von Filmbildungskammern (F21, F22) beinhaltet, die Nebelsprüheinheit eine Mehrzahl von Nebelsprüheinheiten beinhaltet, und die Mehrzahl von Nebelsprüheinheiten in einer entsprechenden Filmbildungskammer aus der Mehrzahl von Filmbildungskammern angeordnet sind.

4. Filmbildungsvorrichtung nach einem der Ansprüche 1 bis 3, wobei
die Heizkammer (H30) eine Heizprozesslänge (LH3) entlang des vorbestimmten Kreises aufweist, die Filmbildungskammer (F30) eine Filmbildungsprozesslänge (LM3) entlang des vorbestimmten Kreises aufweist, eine notwendige Heizzeit (TH3) erforderlich ist, um die Heizbehandlung durchzuführen, und eine notwendige Nebelsprühzeit (TM3) erforderlich ist, um die Nebelsprühbehandlung durchzuführen, und
ein Prozesslängenverhältnis (PL3), das ein Verhältnis der Heizprozesslänge zur Filmbildungsprozesslänge ist, so festgelegt ist, dass es mit einem notwendigen Zeitverhältnis (PT3) übereinstimmt, das ein Verhältnis der notwendigen Heizzeit zur notwendigen Nebelsprühzeit ist.

5. Filmbildungsvorrichtung nach Anspruch 1, wobei
das Substrat ein einzelnes Substrat aufweist,
die Heizkammer (H30) eine Heizprozesslänge (LH3) entlang des vorbestimmten Kreises aufweist, die Filmbildungskammer eine Filmbildungsprozesslänge (LM3) entlang des vorbestimmten Kreises aufweist, die notwendige Heizzeit (TH3) erforderlich ist, um die Heizbehandlung durchzuführen, und die notwendige Nebelsprühzeit (TM3) erforderlich ist, um die Nebelsprühbehandlung durchzuführen, und
hinsichtlich einer Fördergeschwindigkeit (V3) des Substrats entlang des vorbestimmten Kreises mit der Substrattransportvorrichtung eine Fördergeschwindigkeit (V3H) in der Heizkammer und eine Fördergeschwindigkeit (V3M) in der Filmbildungskammer individuell auf der Grundlage der Heizprozesslänge und der Filmbildungsprozesslänge festgelegt werden, so dass sowohl die notwendige Heizzeit als auch die notwendige Nebelsprühzeit erreicht sind.

6. Filmbildungsvorrichtung nach einem der Ansprüche 1 bis 3, wobei
die Nebelsprüheinheit eine Nebelsprühöffnung (21-23) beinhaltet, die zum Sprühen des Quellnebels ausgelegt ist, und
die Nebelsprühöffnung so geformt ist, dass eine Öffnungsfläche auf einer Seite, die weiter von einem Mittelpunkt des vorbestimmten Kreises entfernt ist, breiter ist.

7. Filmbildungsvorrichtung nach einem der Ansprüche 1 bis 3, wobei die Substrattransportvorrichtung beinhaltet:
eine Rotationsmechanismusvorrichtung (8r, 8p), die dazu ausgelegt ist, eine Rotationsoperation zum Fördern des Substrats entlang des vorbestimmten Kreises durchzuführen; und
einen Substrathalter (6, 6A, 6B), der dazu ausgelegt ist, das Substrat zu halten, und der dazu ausgelegt ist, entlang des vorbestimmten Kreises zusammen mit der Rotationsoperation befördert zu werden.

8. Filmbildungsvorrichtung nach Anspruch 7, wobei
das Substrat ein Substrat ist, das in der Draufsicht eine rechteckige Form hat, und
der Substrathalter das Substrat hält, während eine gesamte vordere Oberfläche des Substrats freiliegt und eine gesamte hintere Oberfläche des Substrats mit Ausnahme eines Eckabschnitts freiliegt.

9. Filmbildungsvorrichtung nach einem der Ansprüche 1 bis 3, wobei der Heizmechanismus beinhaltet:
eine erste Richtungsheizeinheit (2), die dazu ausgelegt ist, eine erste Richtungsheizbehandlung zum Erwärmen des Substrats durch Ausstrahlen von Infrarotlicht in eine erste Richtung durchzuführen; und
eine zweite Richtungsheizeinheit (4), die dazu ausgelegt ist, eine zweite Richtungsheizbehandlung zum Erwärmen des Substrats durch Ausstrahlen von Infrarotlicht in eine zweite Richtung durchzuführen, wobei die zweite Richtung eine der ersten Richtung entgegengesetzte Richtung ist, wobei
die Heizbehandlung die erste Richtungsheizbehandlung und die zweite Richtungsheizbehandlung aufweist, die erste Richtung eine Richtung von einer hinteren Oberfläche zu einer vorderen Oberfläche des Substrats ist und die zweite Richtung eine Richtung von der vorderen Oberfläche zu der hinteren Oberfläche des Substrats ist.

10. Filmbildungsvorrichtung nach Anspruch 9, wobei die Nebelsprüheinheit beinhaltet:
eine erste Richtungsnebelsprüheinheit (1L), die dazu ausgelegt ist, eine erste Richtungsnebelsprühbehandlung durchzuführen, bei der der Quellnebel in die erste Richtung gesprüht wird; und
eine zweite Richtungsnebelsprüheinheit (1H), die dazu ausgelegt ist, eine zweite Richtungsnebelsprühbehandlung durchzuführen, bei der der Quellnebel in die zweite Richtung gesprüht wird, wobei
die Richtungsnebelsprühbehandlung die erste Richtungsnebelsprühbehandlung und die zweite Richtungsnebelsprühbehandlung aufweist.

## Revendications

1. Appareil de formation de film comprenant :
une unité de transport de substrat (8) configurée pour transporter un substrat (10) le long d'un cercle prédéterminé ;
un mécanisme de chauffage (2, 4) fourni dans une chambre de chauffage (H10, H21, H22, H30) disposée le long dudit cercle prédéterminé, ledit mécanisme de chauffage étant configuré pour effectuer un traitement de chauffage consistant à chauffer ledit substrat sans toucher ledit substrat dans ladite chambre de chauffage ; et
une unité de pulvérisation de brume (1H, 1L) fournie dans une chambre de formation de film (F10, F21, F22, F30) disposée le long dudit cercle prédéterminé, ladite unité de pulvérisation de brume étant configurée pour effectuer un traitement de pulvérisation de brume consistant à pulvériser de la brume source (MT) vers ledit substrat dans ladite chambre de formation de film, ladite brume source étant obtenue en atomisant une solution source, dans lequel
ladite chambre de chauffage et ladite chambre de formation de film sont disposées séparément l'une de l'autre, et ledit substrat est transporté le long dudit cercle prédéterminé par ladite unité de transport de substrat pour former un film mince sur ledit substrat en effectuant ledit traitement de chauffage dudit mécanisme de chauffage dans ladite chambre de chauffage et ensuite en effectuant ledit traitement de pulvérisation de brume de ladite unité de pulvérisation de brume dans ladite chambre de formation de film.

2. Appareil de formation de film selon la revendication 1, dans lequel ledit substrat inclut une pluralité de substrats.

3. Appareil de formation de film selon la revendication 1 ou 2, dans lequel
ladite chambre de chauffage inclut une pluralité de chambres de chauffage (H21, H22), ledit mécanisme de chauffage inclut une pluralité de mécanismes de chauffage, et ladite pluralité de mécanismes de chauffage sont disposés dans une chambre de chauffage correspondante parmi ladite pluralité de chambres de chauffage, et
ladite chambre de formation de film inclut une pluralité de chambres de formation de film (F21, F22), ladite unité de pulvérisation de brume inclut une pluralité d'unités de pulvérisation de brume, et ladite pluralité d'unités de pulvérisation de brume sont disposées dans une chambre de formation de film correspondante parmi ladite pluralité de chambres de formation de film.

4. Appareil de formation de film selon l'une quelconque des revendications 1 à 3, dans lequel
ladite chambre de chauffage (H30) présente une longueur de processus de chauffage (LH3) le long dudit cercle prédéterminé, ladite chambre de formation de film (F30) présente une longueur de processus de formation de film (LM3) le long dudit cercle prédéterminé, une durée de chauffage nécessaire (TH3) est requise pour effectuer ledit traitement de chauffage, et une durée de pulvérisation de brume nécessaire (TM3) est requise pour effectuer ledit traitement de pulvérisation de brume, et
un rapport de longueur de processus (PL3) étant un rapport entre ladite longueur de processus de chauffage et ladite longueur de processus de formation de film est défini pour correspondre à un rapport de durée nécessaire (PT3) étant un rapport entre ladite durée de chauffage nécessaire et ladite durée de pulvérisation de brume nécessaire.

5. Appareil de formation de film selon la revendication 1, dans lequel ledit substrat inclut un substrat,
ladite chambre de chauffage (H30) présente une longueur de processus de chauffage (LH3) le long dudit cercle prédéterminé, ladite chambre de formation de film présente une longueur de processus de formation de film (LM3) le long dudit cercle prédéterminé, une durée de chauffage nécessaire (TH3) est requise pour effectuer ledit traitement de chauffage, et une durée de pulvérisation de brume nécessaire (TM3) est requise pour effectuer ledit traitement de pulvérisation de brume, et
concernant une vitesse de transport (V3) dudit substrat le long dudit cercle prédéterminé avec ladite unité de transport de substrat, une vitesse de transport (V3H) dans ladite chambre de chauffage et une vitesse de transport (V3M) dans ladite chambre de formation de film sont définies individuellement sur la base de ladite longueur de processus de chauffage et de ladite longueur de processus de formation de film, de sorte qu'à la fois ladite durée de chauffage nécessaire et ladite durée de pulvérisation de brume nécessaire soient satisfaites.

6. Appareil de formation de film selon l'une quelconque des revendications 1 à 3, dans lequel
ladite unité de pulvérisation de brume inclut un orifice de pulvérisation de brume (21-23) configuré pour pulvériser ladite brume source, et
ledit orifice de pulvérisation de brume présente une forme qu'une région d'ouverture est plus large sur un côté plus éloigné d'un point central dudit cercle prédéterminé.

7. Appareil de formation de film selon l'une quelconque des revendications 1 à 3, dans lequel ladite unité de transport de substrat inclut :
une unité de mécanisme de rotation (8r, 8p) configurée pour effectuer une opération de rotation pour transporter ledit substrat le long dudit cercle prédéterminé ; et
un porte-substrat (6, 6A, 6B) configuré pour maintenir ledit substrat, et configuré pour être transporté le long dudit cercle prédéterminé avec ladite opération de rotation.

8. Appareil de formation de film selon la revendication 7, dans lequel
ledit substrat est un substrat présentant une forme rectangulaire en vue planaire, et
ledit porte-substrat maintient ledit substrat tandis qu'une surface avant entière dudit substrat est exposée et qu'une surface arrière entière dudit substrat à l'exception d'une portion de coin est exposée.

9. Appareil de formation de film selon l'une quelconque des revendications 1 à 3, dans lequel ledit mécanisme de chauffage inclut :
une unité de chauffage de première direction (2) configurée pour effectuer un traitement de chauffage de première direction consistant à chauffer ledit substrat en irradiant de la lumière infrarouge vers une première direction ; et
une unité de chauffage de seconde direction (4) configurée pour effectuer un traitement de chauffage de seconde direction consistant à chauffer ledit substrat en irradiant de la lumière infrarouge vers une seconde direction, ladite seconde direction étant une direction opposée à ladite première direction, dans lequel
ledit traitement de chauffage inclut ledit traitement de chauffage de première direction et ledit traitement de chauffage de seconde direction, ladite première direction est une direction depuis une surface arrière jusqu'à une surface avant dudit substrat, et ladite seconde direction est une direction depuis la surface avant jusqu'à la surface arrière dudit substrat.

10. Appareil de formation de film selon la revendication 9, dans lequel ladite unité de pulvérisation de brume inclut :
une unité de pulvérisation de brume de première direction (1L) configurée pour effectuer un traitement de pulvérisation de brume de première direction consistant à pulvériser ladite brume source vers ladite première direction ; et
une unité de pulvérisation de brume de seconde direction (1H) configurée pour effectuer un traitement de pulvérisation de brume de seconde direction consistant à pulvériser ladite brume source vers ladite seconde direction, dans lequel
ledit traitement de pulvérisation de brume inclut ledit traitement de pulvérisation de brume de première direction et ledit traitement de pulvérisation de brume de seconde direction.
